(19) Europäisches Patentamt

European Patent Office

Office européen des brevets

(11) **EP 4 339 997 A1**

(12) **EUROPEAN PATENT APPLICATION**

(43) Date of publication:
**20.03.2024 Bulletin 2024/12**

(21) Application number: **23197464.3**

(22) Date of filing: **14.09.2023**

(51) International Patent Classification (IPC):
***H01J 49/28*** (2006.01)

(52) Cooperative Patent Classification (CPC):
**H01J 49/288**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **14.09.2022 GB 202213502**

(71) Applicant: **Thermo Fisher Scientific (Bremen)
GmbH
28199 Bremen (DE)**

(72) Inventors:
- **WEHRS, Henning
  28199 Bremen (DE)**
- **SCHUESSLER, Jan
  28199 Bremen (DE)**
- **SCHWIETERS, Johannes
  28199 Bremen (DE)**

(74) Representative: **Jarrett, Daniel Phillip et al
Kilburn & Strode LLP
Lacon London
84 Theobalds Road
London WC1X 8NL (GB)**

(54) **SIMULATING A MASS SPECTROMETER COMPRISING A DOUBLE WIEN FILTER**

(57) A computer-implemented method of simulating a mass filter of a mass spectrometer is provided. The mass filter has a bandpass characteristic. The method comprises: receiving a first candidate magnetic field strength and a first candidate electric field strength of the mass filter; based on the received first candidate magnetic and electric field strengths, determining a corresponding centre mass of the mass filter; based on the received first candidate magnetic and electric field strengths, determining the width of a passband of the bandpass characteristic; and determining at least one of a lower or an upper bound of the passband of the bandpass characteristic of the mass filter, the determining of the upper bound comprising adding a first predetermined fraction of the determined width of the passband to the determined centre mass and the determining of the lower bound comprising subtracting a second predetermined fraction of the determined width of the passband from the determined centre mass.

FIG. 2B

## Description

### Field

The present disclosure relates generally to mass spectrometers with a mass filter.

### Background

Multicollector mass spectrometers, such as inductively coupled plasma mass spectrometers (MC-ICP-MS), are instruments used to investigate small differences in the abundance ratios of analysed isotopes.

For example, Strontium (Sr) has 4 isotopes with the following masses and abundances:

| Isotope | 84Sr | 86Sr | 87Sr | 88Sr |
|---|---|---|---|---|
| Abundance | 0.56% | 9.86% | 7% | 82.58% |

With improvements in the accuracy of mass spectrometers during the last century, it became clear that the isotope ratios (87Sr/86Sr $\approx$ 0.7103 or 84Sr/87Sr $\approx$ 0.0535) are not identical across different samples. Furthermore, it became apparent that the accurate determination of Sr isotope ratios is a powerful tool for archaeologists. Since the isotopic composition of the diet of an individual is preserved in the bones of an individual, a statement about the place of birth of an individual can be made when matching the Sr isotope ratios of the bones of a dead body to the Sr isotope ratios of the soil in a specific region.

Besides Sr, there are many other isotope systems which are of interest for scientific or technical questions. Another example is the Rubidium - Strontium (Rb - Sr) dating which makes use of the fact that 87Rb decays into 87Sr with a half-life of about 50 billion years: by determining the 87Sr/86Sr ratio as well as the Rb/Sr ratio of different minerals of a sample, the time elapsed since the sample crystallised can be calculated.

However, the 87Sr cannot be easily mass resolved from the 87Rb (86.909180527 amu to 86.9088774970 amu would require a mass resolving power of more than 200,000, while the upper limit of commercially available isotope ratio mass spectrometers is below 50,000). Isotopic methods that suffer from isotopic interferences as the Rb/Sr method therefore require complex chemical cleaning steps prior to the actual measurement with a mass spectrometer, which makes these methods time consuming and limits them to samples that are available in relatively high quantities.

A solution for this problem is the use of a collision reaction cell: the ions are guided through a cell which is filled with a reactive gas. With an appropriate choice of the gas, one can obtain that the analyte ions are mass-shifted (by forming molecules when reacting with the gas), while the interfering ions are not. For example, the analyte ions become 16 atomic mass units (amu) heavier when reacting with oxygen, while the mass of the interfering ions remains the same.

By doing this, the mass difference of sample ions and interfering ions, which was marginal before entering the collision cell, becomes large enough to be easily resolved by the mass spectrometer downstream of the collision cell.

To avoid the problem of elements that interfere with the mass shifted analyte ions, a pre-mass-filter with a bandpass characteristic can be used, such that only the masses of interest reach the collision cell while ions that interfere with the mass shifted ions are not transmitted. In EP 3 769 334 B1, the entire contents of which are herewith incorporated by reference in this document, a pre-filter comprising a combination of two Wien filters is disclosed. Such a pre-filter can have a mass-independent transmission.

A pre-filter comprising a combination of two Wien filters is suitable for blocking the intense Ar beam caused by the plasma source of ICP-MS instruments as early as possible in the ion optics. By blocking the Ar beam, the total ion load of the ion beam is greatly reduced. This is beneficial for the resolving power of the instrument and, in particular, for the abundance sensitivity. However, optimising the settings of a pre-filter comprising a double Wien filter is not intuitive.

### Summary

Aspects of the present disclosure are defined in the accompanying independent claims.

### Overview of disclosure

A computer-implemented method of simulating a mass filter of a mass spectrometer, the mass filter having a bandpass characteristic is disclosed herein. The method comprises:

receiving a first candidate magnetic field strength and a first candidate electric field strength of the mass filter;

based on the received first candidate magnetic and electric field strengths, determining a corresponding centre mass of the mass filter;

based on the received first candidate magnetic and electric field strengths, determining the width of a passband of the bandpass characteristic; and

determining at least one of a lower or an upper bound of the passband of the bandpass characteristic of the mass filter.

Optionally, the determining of the upper bound comprises adding a first predetermined fraction of the determined width of the passband to the determined centre mass and the determining of the lower bound comprises subtracting a second predetermined fraction of the determined width of the passband from the determined centre mass.

Optionally, the method further comprises displaying the at least one of the upper or lower bound of the passband of the bandpass characteristic of the mass filter.

Optionally, the method further comprises:

receiving a centre mass, optionally from a user; and based on the received centre mass, determining a first updated electric field strength of the mass filter.

Optionally, the method further comprises displaying the first updated electric field strength.

Optionally, the method further comprises:

receiving a second candidate magnetic field strength and a second candidate electric field strength of the mass filter; and

repeating, based on the received second candidate magnetic and electric field strengths, the determining of the corresponding centre mass, the determining of the width of the passband of the bandpass characteristic, and the determining of the at least one of the lower or the upper bound of the passband of the bandpass characteristic.

Optionally, the method further comprises displaying the at least one of the upper or lower bound of the passband of the bandpass characteristic of the mass filter, wherein the repeating comprises repeating the determining of the corresponding centre mass, the determining of the width of the passband of the bandpass characteristic, the determining of the at least one of the lower or the upper bound of the passband of the bandpass characteristic, and the displaying, wherein the first candidate magnetic field strength, the first candidate electric field strength, the second candidate magnetic field strength, and the second candidate electric field strength are received from a user.

Optionally, the method further comprises:

displaying a mass of a carrier gas of the mass spectrometer; and

further optionally, responsive to determining that the mass of the carrier gas is between the upper and lower bound of the passband of the bandpass characteristic of the mass filter, displaying a warning.

Optionally, the method further comprises displaying an operating mass range of one or more multicollector detectors of the mass spectrometer.

Optionally, the method further comprises:

displaying a mass range of an element or molecule of interest,

further optionally wherein the method further comprises receiving from the user a selection of the element or molecule of interest from a plurality of elements and/or molecules.

Optionally, the method further comprises:

subsequent to the repeated displaying, receiving confirmation that the bandpass characteristic of the mass filter is acceptable;

responsive to receiving the confirmation, setting a magnetic field and an electric field of the mass filter to the second candidate magnetic field strength and the second candidate electric field strength, respectively.

Optionally, the method further comprises determining, based on at least one of the upper or lower bounds of the passband of the bandpass characteristic, whether the bandpass characteristic of the mass filter meets one or more acceptance criteria.

Optionally, the repeating is until the bandpass characteristic meets the one or more acceptance criteria.

Optionally, the method further comprises, responsive to determining that the bandpass characteristic meets the one or more acceptance criteria, setting a or the magnetic field and an or the electric field of the mass filter to the candidate magnetic field strength and the candidate electric field strength, respectively, at which the bandpass characteristic was determined to meet the one or more acceptance criteria.

Optionally, determining whether the bandpass characteristic of the mass filter meets one or more acceptance criteria comprises comparing at least one of the upper or lower bound of the passband of the bandpass characteristic of the mass filter with at least one of: the mass of a carrier gas of the mass spectrometer, the operating mass range of one or more multicollector detectors of the mass spectrometer, or the mass range of an element or molecule of interest.

Optionally, the method further comprises, based on the received first candidate magnetic and electric field strengths, determining the width of a lower flank of the bandpass characteristic and the width of an upper flank of the bandpass characteristic, and the determining of the upper bound further comprises adding a third predetermined fraction of the determined width of the upper flank to the determined centre mass and the determining of the lower bound further comprises subtracting a fourth predetermined fraction of the determined width of the lower flank from the determined centre mass.

Optionally, the mass filter comprises a first Wien filter and a second Wien filter, wherein the candidate magnetic field strength and the candidate electric field strength are field strengths of the first and second Wien filters.

There is disclosed an apparatus configured to perform any of the methods described herein.

There is disclosed a computer-readable medium comprising instructions which, when executed by a processor of an apparatus, cause the apparatus to perform any of the methods described herein.

**Brief description of the drawings**

Examples of the present disclosure will now be explained with reference to the accompanying drawings in which:

FIG. 1 is a block diagram of an example scientific instrument support module for performing support operations, in accordance with various implementations.

FIG. 2A is a simplified view of an example instrument system in accordance with various implementations.

FIG. 2B is a simplified diagram of an example static field mass filter of the instrument system in accordance with various implementations.

FIG. 3 is an example of a graphical user interface that may be used in the performance of some or all of the methods disclosed herein, in accordance with various implementations.

FIG. 4 is a block diagram of an example computing device that may perform some or all of the methods disclosed herein, in accordance with various implementations.

FIG. 5 is a block diagram of an example scientific instrument support system in which some or all of the methods disclosed herein may be performed, in accordance with various implementations.

FIG. 6 is a flow diagram of an example method of simulating a static field mass filter of a mass spectrometer, in accordance with various implementations.

FIGs. 7A and 7B are flow diagrams showing example additional steps for the method of FIG. 6, in accordance with various implementations.

FIG. 8 is an example of relationship between centre mass and a bandpass characteristic of a static field mass filter, in accordance with various implementations.

FIGs. 9A and 9B are examples of displaying the bandpass characteristic of the static field mass filter and other parameters, in accordance with various implementations.

Throughout the description and the drawings, like reference numerals refer to like parts. Implementations are illustrated by way of example, not by way of limitation, in the figures of the accompanying drawings.

**Detailed description**

In overview, a method of simulating a mass filter of a mass spectrometer, the mass filter having a bandpass characteristic, is disclosed herein.

The method comprises, in summary, receiving a magnetic field strength and an electric field strength; based on these strengths, determining a centre mass of the mass filter; and, using a relationship between centre mass and width of a bandpass characteristic of the filter, determining the lower and upper bounds of a passband of the filter.

The present approach is for use in a mass spectrometer including a static field mass filter such as (but not limited to) that described in EP 3 769 334 B1 (e.g., Thermo Fisher Scientific's "Neoma™ MS/MS MC-ICP-MS"). Static field mass filters may apply a constant electric field and apply a magnetic field. This leads to a flat transmission of ions across a selected mass-to-charge ratio (m/z) range, and small deviations in system tuning should not change the measured isotope ratio in an unpredictable way. The static field mass filter is able to select a mass window prior to entry of the ions into a reaction cell. Although masses are separated by static magnetic and electric fields, the complete arrangement of the ion optical pre-filter setup does not introduce a lateral mass discrimination for the selected m/z window at the relatively small input aperture of a reaction cell.

Preferably, the static field mass filter comprises a first and a second Wien filters with an inversion lens between them. This arrangement uses static and not time-dependent (RF-based) ion optics to separate the ions and, as a result of the symmetry between the first and second Wien filters and the use of an inversion lens, mass-to-charge separation introduced within the static field mass filter is nullified at the exit thereof. The resulting instrument may be tuned along the path of the ions, because there is a relatively simple relationship between the electric and magnetic fields, and the mass-to-charge ratio of the ions.

The design of a double Wien-filter preceding the standard Neoma™ mass spectrometer in the Neoma™ MS/MS MC-ICP-MS provides a pre-filter which allows unwanted ion beams, such as Argon (Ar), to be cut from the mass spectrum or to clean a mass range for reacting analytes into this mass area for online chemical separation via a collision cell. Tuning this part of the instrument is important for good performance.

In the case of Neoma™ MS/MS a combination of two Wien filters has been chosen for pre-filtering the ions. This is because, to avoid the problem of elements that interfere with the mass shifted analyte ions, a pre-mass-filter with a bandpass characteristic should be used such that only the masses of interest reach the collision cell while ions that interfere with the mass shifted ions are not transmitted. The benefit of using two Wien filters is that it does not require alternating potentials (as in a quadrupole filter) which usually lead to a mass dependent transmission.

Another important function of the pre-filter is to block the intense Ar beam that is apparent in mass spectrometers with a plasma source as early as possible in the ion optics. By blocking the Ar beam the total ion load of the ion beam is greatly reduced, which is beneficial for the resolving power of the instrument and most of all beneficial for the abundance sensitivity.

Optimising the settings of the double Wien filter that is used in the Neoma™ MS/MS for best analytical conditions specific for each isotope system to be analysed is not intuitive for the operator since the parameters that control the transmission behaviour of the pre-filter have overlapping effects on the width of the bandpass, the steepness of its flanks and on the centre mass. A second reason why the tuning is not intuitive is that the flanks of the transmission curve are relatively wide and not symmetrical.

To prevent a trial and error experience for the user while tuning the MS/MS Wien pre-filter settings, the user needs to know which masses are blocked by the pre-filter, which masses are transmitted and how high the transmission efficiency is for each isotope system that is going to be used for subsequent isotope ratio analysis. To aid with these optimization tasks, the instrument software can indicate the transmission behaviour while the operator is changing the MS/MS Wien pre-filter setting (full transmission in the centre of the bandpass, decreasing transmission in proximity to the flanks).

It is noted that the present disclosure is not limited to mass spectrometers having an ICP ion source but can also be applied to mass spectrometers having an electron ionization ion source, a chemical ionization ion source, an electrospray ion source, a matrix-assisted laser desorption/ionization (MALDI) ion source, a photoionization ion source, a glow discharge ionization sources, a thermal ionization source and/or any other suitable ionization source.

The approaches described herein may be implemented using the system(s) or apparatus described below.

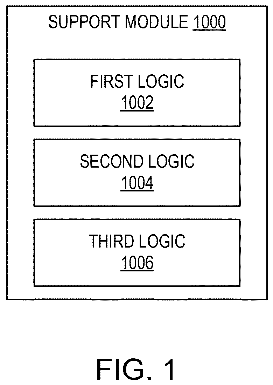

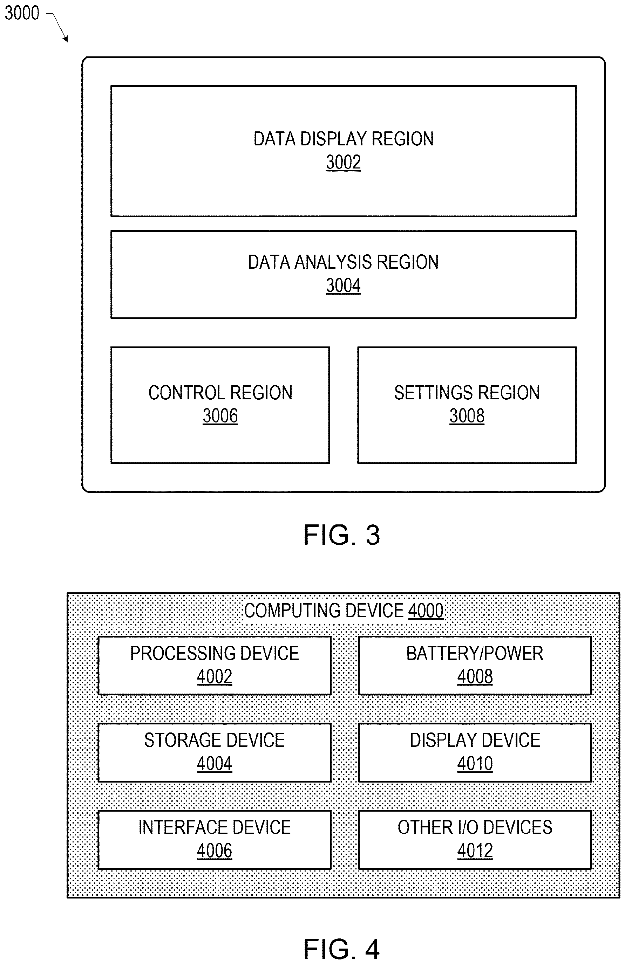

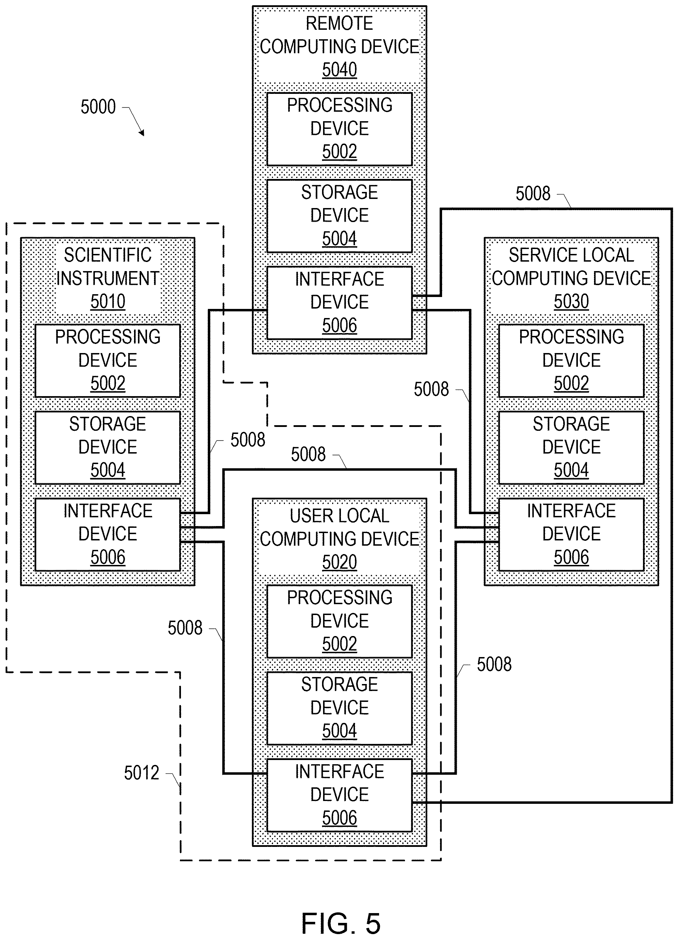

FIG. 1 is a block diagram of a scientific instrument support module 1000 for performing support operations, in accordance with various implementations. The scientific instrument support module 1000 may be implemented by circuitry (e.g., including electrical and/or optical components), such as a programmed computing device. The logic of the scientific instrument support module 1000 may be included in a single computing device, or may be distributed across multiple computing devices that are in communication with each other as appropriate. Examples of computing devices that may, singly or in combination, implement the scientific instrument support module 1000 are discussed herein with reference to the computing device 4000 of FIG. 4. Examples of systems of interconnected computing devices, in which the scientific instrument support module 1000 may be implemented across one or more of the computing devices, are discussed herein with reference to the scientific instrument support system 5000 of FIG. 5.

The scientific instrument support module 1000 may include first logic 1002, second logic 1004, and third logic 1006. As used herein, the term "logic" may include an apparatus that is to perform a set of operations associated with the logic. For example, any of the logic elements included in the support module 1000 may be implemented by one or more computing devices programmed with instructions to cause one or more processing devices of the computing devices to perform the associated set of operations. In a particular implementation, a logic element may include one or more non-transitory computer-readable media having instructions thereon that, when executed by one or more processing devices of one or more computing devices, cause the one or more computing devices to perform the associated set of operations. As used herein, the term "module" may refer to a collection of one or more logic elements that, together, perform a function associated with the module. Different ones of the logic elements in a module may take the same form or may take different forms. For example, some logic in a module may be implemented by a programmed general-purpose processing device, while other logic in a module may be implemented by an application-specific integrated circuit (ASIC). In another example, different ones of the logic elements in a module may be associated with different sets of instructions executed by one or more processing devices. A module may not include all of the logic elements depicted in the associated drawing; for example, a module may include a subset of the logic elements depicted in the associated drawing when that module is to perform a subset of the operations discussed herein with reference to that module.

As mentioned above, the scientific instrument support module 1000 may be implemented in a system of interconnected computing devices. In such a system, the scientific instrument support module 1000 may interact with a scientific instrument 5010 (the interaction with which is discussed herein with reference to FIG. 5) which may include any appropriate scientific instrument, such as a mass spectrometer 200 having a static field mass filter 204. Alternatively, even though the implementations described below refer to a static field mass filter 204, any other suitable filter (such as a multipole, e.g., quadrupole, filter) may be used instead of the static field mass filter 204.

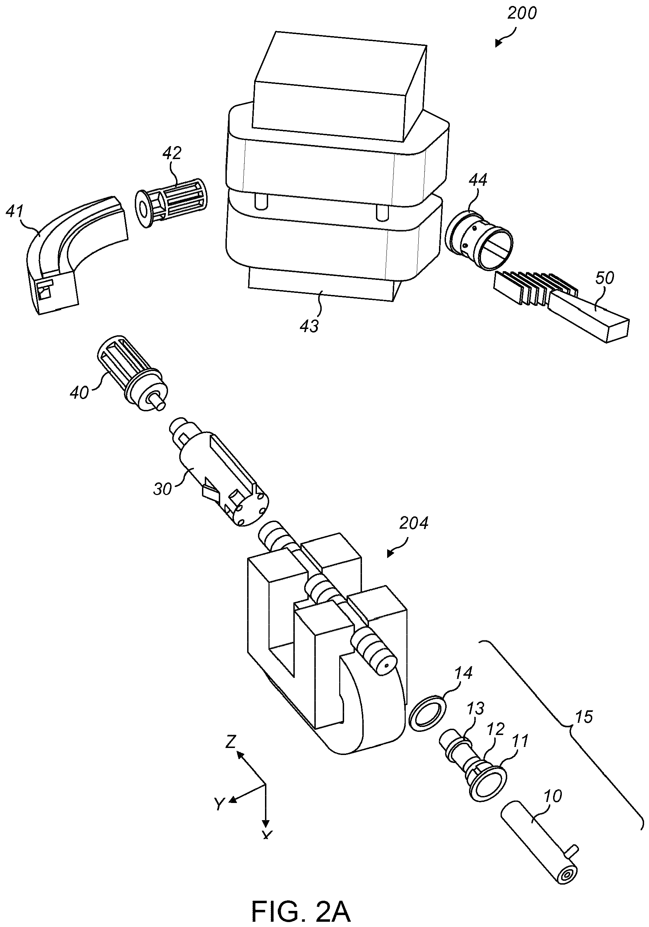

FIG. 2A shows a view of an example mass spectrometer 200 having a static field mass filter 204.

The mass spectrometer 200 includes an ion source 15. The ion source 15 includes a triaxial ICP torch 10, a sampler cone 11, one or more skimmer cones 12, an extraction lens 13 and/or a further skimmer cone 14 and/or another ion optical device 14. This results in a collimated ion beam.

Downstream of the ion source 15, instead of a quadrupole (RF) mass filter, is positioned a static field mass filter 204 which will be described in further detail below. The static field mass filter 204 maintains constant electric and magnetic fields, so that transmission of ions through the static field mass filter has a predictable and, in most cases, flat response across the selected m/z range. A quadrupole mass filter does not provide such a flat response. This is because the ions are only influenced by static fields. In a quadrupole mass filter, the electromagnetic fields change with time according to the applied frequency. This results in a sinusoidal trajectory of the ions which are pushed back and forth. Moreover, small deviations in system tuning of the static field mass filter 204 do not change the measured isotope ratio in an unpredictable way. Nevertheless, the static field mass filter 204 does not introduce a lateral mass discrimination (as would happen in, for example, a magnetic sector analyser) so that the ion beam exiting the static field mass filter 204 can be focussed onto the relatively small (c. 2mm) entrance aperture of a collision cell 219, across the width of the mass window selected for transmission by the static field mass filter 204.

Following the collision cell 219, ions are accelerated by an accelerator 40 and focussed into the ion optics of a double focusing high resolution multicollector mass spectrometer for simultaneous detection of different isotopes (of the sample or standards). Further, the double focusing high resolution multicollector mass spectrometer again includes an electrostatic sector 41 and a magnetostatic sector 43, separated by a focussing lens 42. Downstream of the high resolution multicollector mass spectrometer, the arrangement contains dispersion optics 44 and finally a detector platform 50 again, for example, such as that described in GB-A-2,541,391.

The preferred arrangement of a static field mass filter 204 in the arrangement of FIG. 2A is a double Wien filter. Wien filters employ an arrangement of crossed electrostatic and magnetostatic fields. Ions passing through this arrangement are subject to the magnetic Lorentz force and the electric field strength.

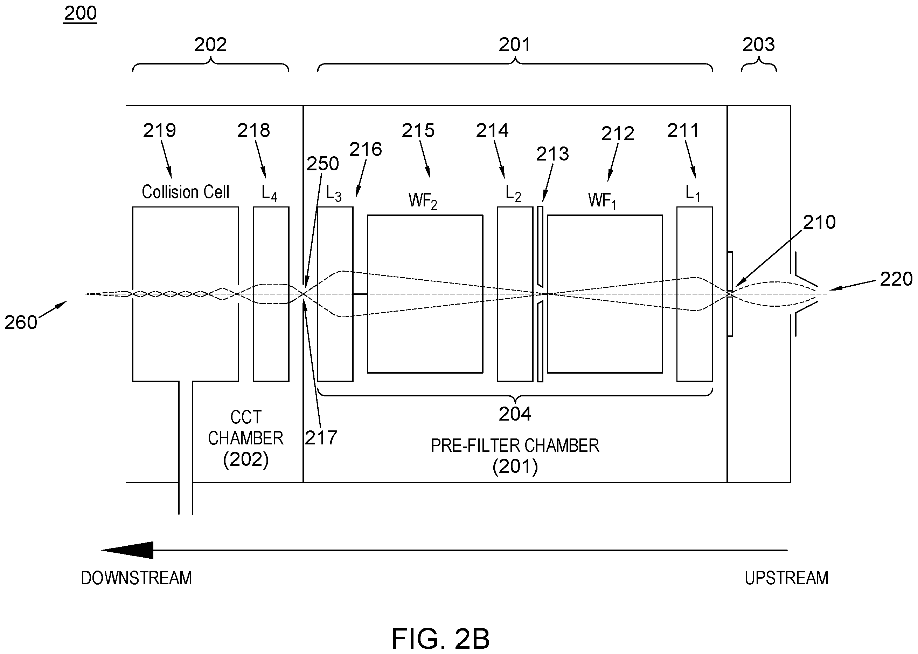

FIG. 2B is simplified diagram of a pre-filter chamber 201 of a mass spectrometer 200 having a static field mass filter 204 in which some or all of the methods disclosed herein may be performed, in accordance with various implementations.

The mass spectrometer also has a collision cell chamber 202 and an injection extraction area 203, respectively downstream and upstream of the pre-filter chamber 201.

The mass spectrometer 200 may also include a mass analyser (not shown) downstream of the collision cell chamber 202 shown in FIG. 2B.

The pre-filter chamber 201 of the mass spectrometer 200 may comprise an entrance aperture 210, a static field mass filter 204, and an exit aperture 217. The static field mass filter 204 may comprise a first lens (or 'lens one') 211, a first Wien filter 212, a slit 213 (which can be narrowed to a minimum slit width and widened to a width larger than the minimum slit width), a second lens (or 'lens two') 214, a second Wien filter 215, and a third lens (or 'lens three') 216.

The collision cell chamber 202 may comprise a fourth lens (or 'lens four') 218 and a collision cell 219.

The extraction area 203 may comprise an extraction lens (not shown) for injecting a beam of ions 220 comprising one or more ion species into the pre-filter chamber 201 through entrance aperture 210.

The beam 220 may pass through the pre-filter chamber 201 and exit from exit aperture 217 to yield beam 250. The beam 250 exiting the pre-filter chamber 201 may enter the collision cell chamber 202. In the collision cell chamber 202, exiting beam 250 may pass through fourth lens 218 and collision cell 219 to yield beam 260.

The methods disclosed herein may include interactions with a human user (e.g., via the user local computing device 5020 discussed herein with reference to FIG. 5). These interactions may include providing information to the user (e.g., information regarding the operation of a scientific instrument such as the scientific instrument 5010 of FIG. 5, information regarding a sample being analysed or other test or measurement performed by a scientific instrument, information retrieved from a local or remote database, or other information) or providing an option for a user to input commands (e.g., to control the operation of a scientific instrument such as the scientific instrument 5010 of FIG. 5, or to control the analysis of data generated by a scientific instrument), queries (e.g., to a local or remote database), or other information. In some implementations, these interactions may be performed through a graphical user interface (GUI) that includes a visual display on a display device (e.g., the display device 4010 discussed herein with reference to FIG. 4) that provides outputs to the user and/or prompts the user to provide inputs (e.g., via one or more input devices, such as a keyboard, mouse, trackpad, or touchscreen, included in the other I/O devices 4012 discussed herein with reference to FIG. 4). The scientific instrument support systems disclosed herein may include any suitable GUIs for interaction with a user.

FIG. 3 depicts an example GUI 3000 that may be used in the performance of some or all of the methods disclosed herein, in accordance with various implementations. As noted above, the GUI 3000 may be provided on a display device (e.g., the display device 4010 discussed herein with reference to FIG. 4) of a computing device (e.g., the computing device 4000 discussed herein with reference to FIG. 4) of a scientific instrument support system (e.g., the scientific instrument support system 5000 discussed herein with reference to FIG. 5), and a user may interact with the GUI 3000 using any suitable input device (e.g., any of the input devices included in the other I/O devices 4012 discussed herein with reference to FIG. 4) and input technique (e.g., movement of a cursor, motion capture, facial recognition, gesture detection, voice recognition, actuation of buttons, etc.).

The GUI 3000 may include a data display region 3002, a data analysis region 3004, a scientific instrument control region 3006, and a settings region 3008. The particular number and arrangement of regions depicted in FIG. 3 is simply illustrative, and any number and arrangement of regions, including any desired features, may be included in a GUI 3000.

The data display region 3002 may display data generated by a scientific instrument (e.g., the scientific instrument 5010 discussed herein with reference to FIG. 5). For example, the data display region 3002 may display a bandpass characteristic of the static field mass filter, any masses, and/or any ranges according to the methods disclosed herein.

The data analysis region 3004 may display the results of data analysis (e.g., the results of analysing the data illustrated in the data display region 3002 and/or other data). For example, the data analysis region 3004 may display a lower or an upper bound of the passband of the bandpass characteristic of the static field mass filter according to the methods disclosed herein. In some implementations, the data display region 3002 and the data analysis region 3004 may be combined in the GUI 3000 (e.g., to include data output from a scientific instrument, and some analysis of the data, in a common graph or region).

The scientific instrument control region 3006 may include options that allow the user to control a scientific instrument (e.g., the scientific instrument 5010 discussed herein with reference to FIG. 5). For example, the scientific instrument control region 3006 may include controls to set the electric field and/or the magnetic field applied in the first Wien filter 212 or the second Wien filter 215 as described in further detail below.

The settings region 3008 may include options that allow the user to control the features and functions of the GUI 3000 (and/or other GUIs) and/or perform common computing operations with respect to the data display region 3002 and data analysis region 3004 (e.g., saving data on a storage device, such as the storage device 4004 discussed herein with reference to FIG. 4, sending data to another user, labelling data, etc.). For example, the settings region 3008 may include settings to switch between automated and manual modes of tuning the mass spectrometer 200.

As noted above, the scientific instrument support module 1000 may be implemented by one or more computing devices. FIG. 4 is a block diagram of a computing device 4000 that may perform some or all of the methods disclosed herein, in accordance with various implementations. In some implementations, the scientific instrument support module 1000 may be implemented by a single computing device 4000 or by multiple computing devices 4000. Further, as discussed below, a computing device 4000 (or multiple computing devices 4000) that implements the scientific instrument support module 1000 may be part of one or more of the scientific instrument 5010, the user local computing device 5020, the service local computing device 5030, or the remote computing device 5040 of FIG. 5.

The computing device 4000 of FIG. 4 is illustrated as having a number of components, but any one or more of these components may be omitted or duplicated, as suitable for the application and setting. In some implementations, some or all of the components included in the computing device 4000 may be attached to one or more motherboards and enclosed in a housing (e.g., including plastic, metal, and/or other materials). In some implementations, some these components may be fabricated onto a single system-on-a-chip (SoC) (e.g., an SoC may include one or more processing devices 4002 and one or more storage devices 4004). Additionally, in various implementations, the computing device 4000 may not include one or more of the components illustrated in FIG. 4, but may include interface circuitry (not shown) for coupling to the one or more components using any suitable interface (e.g., a Universal Serial Bus (USB) interface, a High-Definition Multimedia Interface (HDMI) interface, a Controller Area Network (CAN) interface, a Serial Peripheral Interface (SPI) interface, an Ethernet interface, a wireless interface, or any other appropriate interface). For example, the computing device 4000 may not include a display device 4010, but may include display device interface circuitry (e.g., a connector and driver circuitry) to which a display device 4010 may be coupled.

The computing device 4000 may include a processing device 4002 (e.g., one or more processing devices). As used herein, the term "processing device" may refer to any device or portion of a device that processes electronic data from registers and/or memory to transform that electronic data into other electronic data that may be stored in registers and/or memory. The processing device 4002 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices.

The computing device 4000 may include a storage device 4004 (e.g., one or more storage devices). The storage device 4004 may include one or more memory devices such as random access memory (RAM) (e.g., static RAM (SRAM) devices, magnetic RAM (MRAM) devices, dynamic RAM (DRAM) devices, resistive RAM (RRAM) devices, or conductive-bridging RAM (CBRAM) devices), hard drive-based memory devices, solid-state memory devices, networked drives, cloud drives, or any combination of memory devices. In some implementations, the storage device 4004 may include memory that shares a die with a processing device 4002. In such an implementation, the memory may be used as cache memory and may include embedded dynamic random access memory (eDRAM) or spin transfer torque magnetic random access memory (STT-MRAM), for example. In some implementations, the storage device 4004 may include computer readable media having instructions thereon that, when executed by one or more processing devices (e.g., the processing device 4002), cause the computing device 4000 to perform any appropriate ones of or portions of the methods disclosed herein. The computer-readable media may be transitory (e.g., a wire or a wireless propagation medium in which a signal is being transmitted) or non-transitory.

The computing device 4000 may include an interface device 4006 (e.g., one or more interface devices 4006). The interface device 4006 may include one or more communication chips, connectors, and/or other hardware and software to govern communications between the computing device 4000 and other computing devices. For example, the interface device 4006 may include circuitry for managing wireless communications for the transfer of data to and from the computing device 4000. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some implementations they might not. Circuitry included in the interface device 4006 for managing wireless communications may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). In some implementations, circuitry included in the interface device 4006 for managing wireless communications may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. In some implementations, circuitry included in the interface device 4006 for managing wireless communications may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). In some implementations, circuitry included in the interface device 4006 for managing wireless communications may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. In some implementations, the interface device 4006 may include one or more antennas (e.g., one or more antenna arrays) for receipt and/or transmission of wireless communications.

In some implementations, the interface device 4006 may include circuitry for managing wired communications, such as electrical, optical, or any other suitable communication protocols. For example, the interface device 4006 may include circuitry to support communications in accordance with Ethernet technologies. In some implementations, the interface device 4006 may support both wireless and wired communication, and/or may support multiple wired communication protocols and/or multiple wireless communication protocols. For example, a first set of circuitry of the interface device 4006 may be dedicated to shorter-range wireless communications such as Wi-Fi or Bluetooth, and a second set of circuitry of the interface device 4006 may be dedicated to longer-range wireless communications such as global positioning system (GPS), EDGE, GPRS, CDMA, WiMAX, LTE, EV-DO, or others. In some implementations, a first set of circuitry of the interface device 4006 may be dedicated to wireless communications, and a second set of circuitry of the interface device 4006 may be dedicated to wired communications.

The computing device 4000 may include battery/power circuitry 4008. The battery/power circuitry 4008 may include one or more energy storage devices (e.g., batteries or capacitors) and/or circuitry for coupling components of the computing device 4000 to an energy source separate from the computing device 4000 (e.g., AC line power).

The computing device 4000 may include a display device 4010 (e.g., multiple display devices). The display device 4010 may include any visual indicators, such as a heads-up display, a computer monitor, a projector, a touchscreen display, a liquid crystal display (LCD), a light-emitting diode (LED) display, or a flat panel display.

The computing device 4000 may include other input/output (I/O) devices 4012. The other I/O devices 4012 may include one or more audio output devices (e.g., speakers, headsets, earbuds, alarms, etc.), one or more audio input devices (e.g., microphones or microphone arrays), location devices (e.g., GPS devices in communication with a satellite-based system to receive a location of the computing device 4000, as known in the art), audio codecs, video codecs, printers, sensors (e.g., thermocouples or other temperature sensors, humidity sensors, pressure sensors, vibration sensors, accelerometers, gyroscopes, etc.), image capture devices such as cameras, keyboards, cursor control devices such as a mouse, a stylus, a trackball, or a touchpad, bar code readers, Quick Response (QR) code readers, or radio frequency identification (RFID) readers, for example.

The computing device 4000 may have any suitable form factor for its application and setting, such as a handheld or mobile computing device (e.g., a cell phone, a smart phone, a mobile internet device, a tablet computer, a laptop computer, a netbook computer, an ultrabook computer, a personal digital assistant (PDA), an ultramobile personal computer, etc.), a desktop computing device, or a server computing device or other networked computing component.

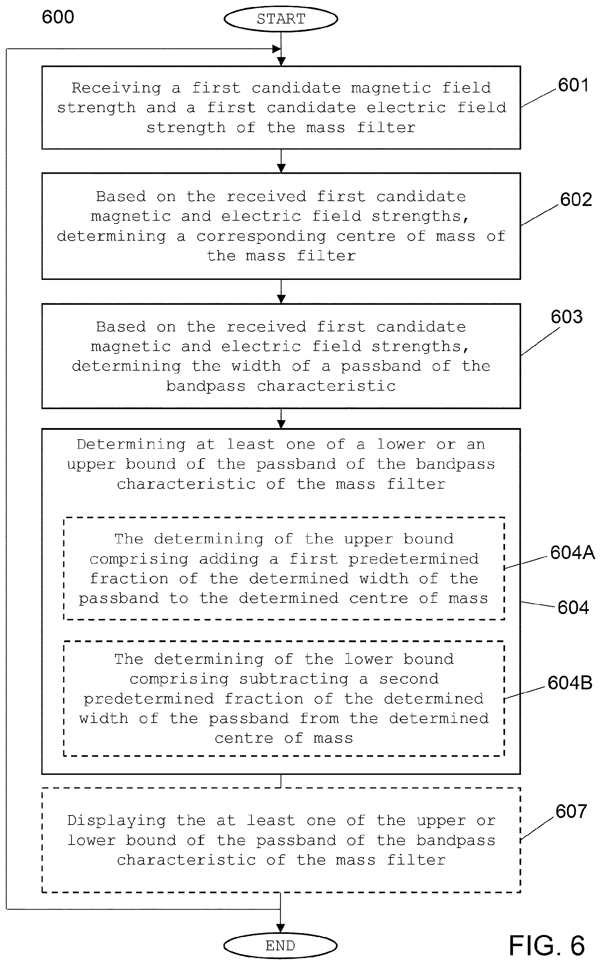

One or more computing devices implementing any of the scientific instrument support modules or methods disclosed herein may be part of a scientific instrument support system. FIG. 5 is a block diagram of an example scientific instrument support system 5000 in which some or all of the methods disclosed herein may be performed, in accordance with various implementations. The scientific instrument support modules and methods disclosed herein (e.g., the scientific instrument support module 1000 of FIG. 1 and the method 600 of FIG. 6) may be implemented by one or more of the scientific instrument 5010, the user local computing device 5020, the service local computing device 5030, or the remote computing device 5040 of the scientific instrument support system 5000.

Any of the scientific instrument 5010, the user local computing device 5020, the service local computing device 5030, or the remote computing device 5040 may include any of the implementations of the computing device 4000 discussed herein with reference to FIG. 4, and any of the scientific instrument 5010, the user local computing device 5020, the service local computing device 5030, or the remote computing device 5040 may take the form of any appropriate ones of the implementations of the computing device 4000 discussed herein with reference to FIG. 4.

The scientific instrument 5010, the user local computing device 5020, the service local computing device 5030, or the remote computing device 5040 may each include a processing device 5002, a storage device 5004, and an interface device 5006. The processing device 5002 may take any suitable form, including the form of any of the processing devices 4002 discussed herein with reference to FIG. 4, and the processing devices 5002 included in different ones of the scientific instrument 5010, the user local computing device 5020, the service local computing device 5030, or the remote computing device 5040 may take the same form or different forms. The storage device 5004 may take any suitable form, including the form of any of the storage devices 5004 discussed herein with reference to FIG. 4, and the storage devices 5004 included in different ones of the scientific instrument 5010, the user local computing device 5020, the service local computing device 5030, or the remote computing device 5040 may take the same form or different forms. The interface device 5006 may take any suitable form, including the form of any of the interface devices 4006 discussed herein with reference to FIG. 4, and the interface devices 5006 included in different ones of the scientific instrument 5010, the user local computing device 5020, the service local computing device 5030, or the remote computing device 5040 may take the same form or different forms.

The scientific instrument 5010, the user local computing device 5020, the service local computing device 5030, and the remote computing device 5040 may be in communication with other elements of the scientific instrument support system 5000 via communication pathways 5008. The communication pathways 5008 may communicatively couple the interface devices 5006 of different ones of the elements of the scientific instrument support system 5000, as shown, and may be wired or wireless communication pathways (e.g., in accordance with any of the communication techniques discussed herein with reference to the interface devices 4006 of the computing device 4000 of FIG. 4). The particular scientific instrument support system 5000 depicted in FIG. 5 includes communication pathways between each pair of the scientific instrument 5010, the user local computing device 5020, the service local computing device 5030, and the remote computing device 5040, but this "fully connected" implementation is simply illustrative, and in various implementations, various ones of the communication pathways 5008 may be absent. For example, in some implementations, a service local computing device 5030 may not have a direct communication pathway 5008 between its interface device 5006 and the interface device 5006 of the scientific instrument 5010, but may instead communicate with the scientific instrument 5010 via the communication pathway 5008 between the service local computing device 5030 and the user local computing device 5020 and the communication pathway 5008 between the user local computing device 5020 and the scientific instrument 5010.

The scientific instrument 5010 may include any appropriate scientific instrument, such as mass spectrometer 200 having a static field mass filter 204.

The user local computing device 5020 may be a computing device (e.g., in accordance with any of the implementations of the computing device 4000 discussed herein) that is local to a user of the scientific instrument 5010. In some implementations, the user local computing device 5020 may also be local to the scientific instrument 5010, but this need not be the case; for example, a user local computing device 5020 that is in a user's home or office may be remote from, but in communication with, the scientific instrument 5010 so that the user may use the user local computing device 5020 to control and/or access data from the scientific instrument 5010. In some implementations, the user local computing device 5020 may be a laptop, smartphone, or tablet device. In some implementations the user local computing device 5020 may be a portable computing device.

The service local computing device 5030 may be a computing device (e.g., in accordance with any of the implementations of the computing device 4000 discussed herein) that is local to an entity that services the scientific instrument 5010. For example, the service local computing device 5030 may be local to a manufacturer of the scientific instrument 5010 or to a third-party service company. In some implementations, the service local computing device 5030 may communicate with the scientific instrument 5010, the user local computing device 5020, and/or the remote computing device 5040 (e.g., via a direct communication pathway 5008 or via multiple "indirect" communication pathways 5008, as discussed above) to receive data regarding the operation of the scientific instrument 5010, the user local computing device 5020, and/or the remote computing device 5040 (e.g., the results of self-tests of the scientific instrument 5010, calibration coefficients used by the scientific instrument 5010, the measurements of sensors associated with the scientific instrument 5010, etc.). In some implementations, the service local computing device 5030 may communicate with the scientific instrument 5010, the user local computing device 5020, and/or the remote computing device 5040 (e.g., via a direct communication pathway 5008 or via multiple "indirect" communication pathways 5008, as discussed above) to transmit data to the scientific instrument 5010, the user local computing device 5020, and/or the remote computing device 5040 (e.g., to update programmed instructions, such as firmware, in the scientific instrument 5010, to initiate the performance of test or calibration sequences in the scientific instrument 5010, to update programmed instructions, such as software, in the user local computing device 5020 or the remote computing device 5040, etc.). A user of the scientific instrument 5010 may utilize the scientific instrument 5010 or the user local computing device 5020 to communicate with the service local computing device 5030 to report a problem with the scientific instrument 5010 or the user local computing device 5020, to request a visit from a technician to improve the operation of the scientific instrument 5010, to order consumables or replacement parts associated with the scientific instrument 5010, or for other purposes.

The remote computing device 5040 may be a computing device (e.g., in accordance with any of the implementations of the computing device 4000 discussed herein) that is remote from the scientific instrument 5010 and/or from the user local computing device 5020. In some implementations, the remote computing device 5040 may be included in a datacentre or other large-scale server environment. In some implementations, the remote computing device 5040 may include network-attached storage (e.g., as part of the storage device 5004). The remote computing device 5040 may store data generated by the scientific instrument 5010, perform analyses of the data generated by the scientific instrument 5010 (e.g., in accordance with programmed instructions), facilitate communication between the user local computing device 5020 and the scientific instrument 5010, and/or facilitate communication between the service local computing device 5030 and the scientific instrument 5010.

In some implementations, one or more of the elements of the scientific instrument support system 5000 illustrated in FIG. 5 may not be present. Further, in some implementations, multiple ones of various ones of the elements of the scientific instrument support system 5000 of FIG. 5 may be present. For example, a scientific instrument support system 5000 may include multiple user local computing devices 5020 (e.g., different user local computing devices 5020 associated with different users or in different locations). In another example, a scientific instrument support system 5000 may include multiple scientific instruments 5010, all in communication with service local computing device 5030 and/or a remote computing device 5040; in such an implementation, the service local computing device 5030 may monitor these multiple scientific instruments 5010, and the service local computing device 5030 may cause updates or other information to be "broadcast" to multiple scientific instruments 5010 at the same time. Different ones of the scientific instruments 5010 in a scientific instrument support system 5000 may be located close to one another (e.g., in the same room) or farther from one another (e.g., on different floors of a building, in different buildings, in different cities, etc.). In some implementations, a scientific instrument 5010 may be connected to an Internet-of-Things (IoT) stack that allows for command and control of the scientific instrument 5010 through a web-based application, a virtual or augmented reality application, a mobile application, and/or a desktop application. Any of these applications may be accessed by a user operating the user local computing device 5020 in communication with the scientific instrument 5010 by the intervening remote computing device 5040. In some implementations, a scientific instrument 5010 may be sold by the manufacturer along with one or more associated user local computing devices 5020 as part of a local scientific instrument computing unit 5012.

In some implementations, different ones of the scientific instruments 5010 included in a scientific instrument support system 5000 may be different types of scientific instruments 5010. In some such implementations, the remote computing device 5040 and/or the user local computing device 5020 may combine data from different types of scientific instruments 5010 included in a scientific instrument support system 5000.

As mentioned above, methods may be performed using scientific instrument support system 5000. A method 600 of simulating a static field mass filter 204 of a mass spectrometer 200 comprises steps 601 to 604 and, optionally, 607, shown in FIG 6. The static field mass filter may comprise a first Wien filter 212 and a second Wien filter 215. The static field mass filter may have a bandpass characteristic 800B.

At step 601, a first candidate magnetic field strength 905 and a first candidate electric field strength 906 of the static field mass filter may be received. The candidate magnetic field strength and the candidate electric field strength may be field strengths of the first 212 and second 215 Wien filters. The first candidate magnetic field strength 905 and first candidate electric field strength 906 of the static field mass filter may be received/input in the form of a respective fraction of a predetermined maximum magnetic field strength and electric field strength, respectively.

The first candidate magnetic field strength and the first candidate electric field strength are first approximations of the magnetic and electric field strengths which could be suitable for an analyte comprising one or more elements or molecules of interest.

Either or both of the first candidate magnetic field strength and the first candidate electric field strength may be received from a user.

In addition, selection of the analyte may be received from the user (e.g., from a dropdown menu or by way of the user inputting a description of the analyte), and the receiving of either or both of the first candidate magnetic field strength and the first candidate electric field strength may be subsequent to a determination of the first candidate magnetic field strength and/or the first candidate electric field strength based on the selection. For example, the first candidate electric field strength may be determined as an electric field strength that, given the received first candidate magnetic field strength, would yield a centre mass of the static field filter that is equal to the average of the masses of the one or more elements or molecules of interest. Such a determination may be made based on a theoretical or empirically derived relationship between magnetic and electric field strength and centre mass.

At step 602, based on the received first candidate magnetic 905 and electric 906 field strengths, a corresponding centre mass 800A of the static field mass filter 204 may be determined. Such a determination may be made based on a theoretical or empirically derived relationship between magnetic and electric field strength and centre mass. Such a determination may be particularly straightforward if, for example, the received candidate electric field strength was determined so as to yield a particular centre mass for the static field mass filter 204, as described above.

As one example, the centre mass may be determined by rearranging the following equation:

$$U_{Wien} = const \cdot \sqrt{\frac{E}{m}} \cdot d \cdot B$$

where:

  $U_{Wien}$: voltage that produces the electric field [V]
  const: a constant relating to the construction and dimensions of the static field mass filter 204, which may have a value in a range from 20 to 60, more specifically in a range from 30 to 50;
  E: kinetic energy[eV]
  m: centre mass [amu]
  d: magnetic gap between pole pieces of first and second Wien filters [m]
  B: magnetic field strength [T]

This equation is based on the ion optical theory of the double Wien filter; it will be appreciated that other theories will yield alternative theoretically derived equations. The centre mass may be described as a mass within the pass band, typically in or near the middle of the pass band.

The characterising features of the bandpass (widths of the flanks, full transmission value, etc.) are derived from polynomial curves that have been fitted to describe the results of empirical measurements on a (prototype) instrument.

This approach combines physical equations and a mathematical description of empirical measurements on an actual double Wien filter arrangement. It will be appreciated that other approaches to a bandpass description could serve as a basis for the simulation of a pre-filter.

At step 603, based on the received first candidate magnetic and electric field strengths, the width 804 of a passband 801 of the bandpass characteristic 800B may be determined.

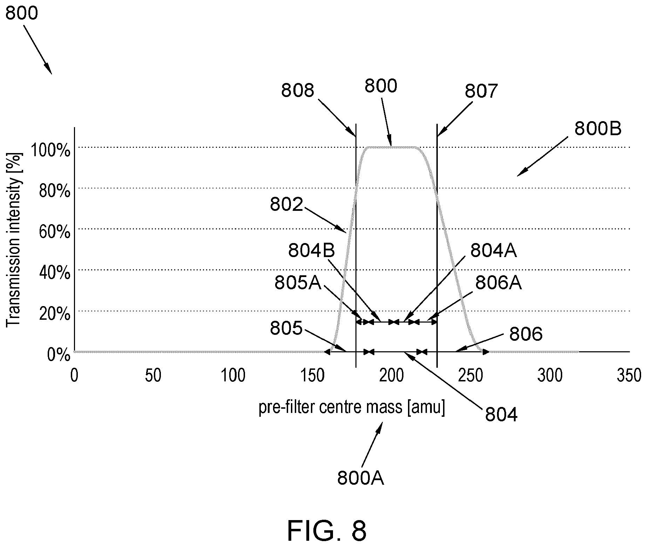

An example of relationship 800 between centre mass 800A and bandpass characteristic 800B is shown in FIG. 8. The bandpass characteristic may have a passband 801, a lower flank 802, and an upper flank 803. The passband, lower flank, and upper flank may have, respectively, widths 804, 805, and 806. The passband may have an upper bound 807 and a lower bound 808.

For example, the centre mass 800A may be related to the bandpass characteristic 800B by measuring the bandpass characteristic on the mass spectrometer of interest. The measurements should use the values for the electric field and/or the magnetic field of the static field mass filter as input values, which may in turn be based on the analyte mass selected by the user.

At step 604, at least one of a lower 808 or an upper 807 bound of the passband 801 of the bandpass characteristic 800B of the static field mass filter 204 may be determined.

Optionally, determining the upper bound 807 (step 604A) may comprise adding a first predetermined fraction 804A (e.g., 0.4 or 0.5) of the determined width 804 of the passband to the determined centre mass 800A, and, optionally, determining the lower bound 808 (step 604B) may comprise subtracting a second predetermined fraction 804B (e.g., 0.4 or 0.5) of the determined width 804 of the passband 801 from the determined centre mass 800A.

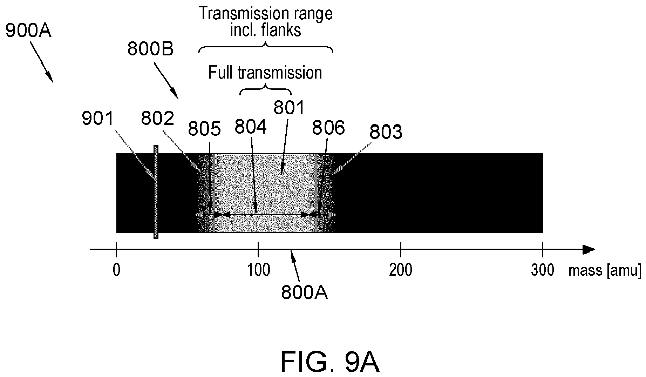

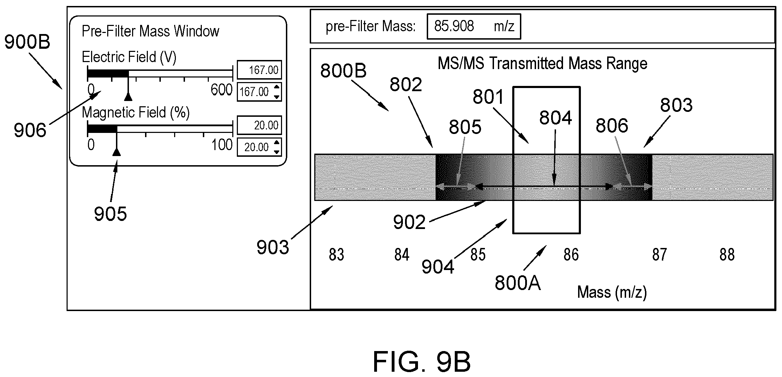

Optionally, at step 607, the at least one of the upper or lower bound of the passband of the bandpass characteristic of the static field mass filter may be displayed, as illustrated in FIGs. 9A and 9B. In addition, further portions of, or the full, bandpass characteristic may be displayed. In both cases, the displaying may be in graphical or numerical form. In some implementations, the at least one of the upper or lower bound of the passband may be marked on the bandpass characteristic displayed in graphical form.

Optionally, method 600 may further comprise receiving a centre mass (e.g., from a user) and, based on the received centre mass, determining a first updated electric field strength of the static field mass filter. Additionally, method 600 may comprise displaying the first updated electric field strength.

The steps of FIG. 6 may be repeated one or more times. Accordingly, in step 601, a second candidate magnetic field strength and a second candidate electric field strength of the static field mass filter may be received. In step 602, based on the received second candidate magnetic and electric field strengths, a second corresponding centre mass of the static field mass filter 204 may be determined. In step 603, based on the relationship between centre mass and the bandpass characteristic, a second width of the passband of the (updated) bandpass characteristic may be determined based on the second centre mass. In step 604, at least one of a lower or an upper bound of the passband of the (updated) bandpass characteristic of the static field mass filter may be determined based on the second centre mass. Optionally, in step 607, the at least one of the upper or lower bound of the passband of the (updated) bandpass characteristic of the static field mass filter may be displayed.

In an example implementation, the user/operator may select the mass of an analyte centre mass and a real time visualization in a user interface may indicate the effect of changing the electric field and magnetic field of the static field mass filter. Thus, the trade-off between a narrow transmission window with steep flanks and a wide window with flat flanks becomes visible, so that the user can more easily find the optimal (or a quasi-optimal) electric field and magnetic field for the analytical application of interest. For example, the user may want to perform an oxygen reaction in the collision cell, therefore there should be little to no transmission at and above 46TiO (mass 62amu), while all Ti masses (46 to 50amu) should be fully transmitted and therefore between the upper and lower bounds.

In some implementations, method 600 may further comprise any of the following:

- displaying a mass 901 of a carrier gas of the mass spectrometer and, optionally, responsive to determining that the mass of the carrier gas is between the upper and lower bound of the passband of the bandpass characteristic of the static field mass filter, displaying a warning 902;

- displaying an operating mass range 904 of one or more multicollector detectors of the mass spectrometer; and/or

- displaying one or more mass ranges 903 of one or more elements or molecules of interest (e.g., of the selected one or more elements or molecules of interest), and, optionally, receiving from the user a selection of the element or molecule of interest from a plurality of elements and/or molecules - for example, if Hafnium (Hf) is selected, the mass range (142 to 150 amu) of Hf is displayed; if TiO (Titanium Oxide) is selected, the Ti mass range (46 to 50 amu) and TiO mass range (62 to 66 amu) are displayed.

The mass of a carrier gas of the mass spectrometer, the operating mass range of one or more multicollector detectors of the mass spectrometer, and/or the one or more mass ranges of one or more elements or molecules of interest may be displayed together with at least one of the upper or lower bound of the passband of the bandpass characteristic of the static field mass filter (e.g., during step 607).

FIG. 9A and 9B show example visualisations 900A, 900B displaying various quantities in accordance with implementations described herein. In FIG. 9A, a bandpass characteristic 800B is shown, as a function of centre mass, centred around centre mass 800A (given, e.g., in amu or m/z units). The passband 801, lower flank 802, and upper flank 803 and their respective widths 804, 805, 806 are also shown. FIG. 9A also shows the position 901 in the mass spectrum of a mass of a carrier gas of the mass spectrometer. A similar visualisation is shown in FIG. 9B. FIG. 9B also displays the bandpass characteristic 800B in a first colour 902 (e.g., green) which indicates that the mass of the carrier gas is not between the upper and lower bound of the passband of the bandpass characteristic of the static field mass filter. If the mass of the carrier gas were between the upper and lower bound, then the bandpass characteristic 800B may be displayed in a second, different colour (e.g., red) indicating a warning. The use of colour as a warning is advantageous because it can be immediately seen by the user while checking the bandpass characteristic. Also shown are an operating mass range 904 of one or more multicollector detectors of the mass spectrometer, and a mass range 903 of an element or molecule of interest.

Referring to FIG. 9B, as part of the same visualisation (or alternatively in a separate visualisation), the received candidate magnetic 905 and electric 906 field strengths may be displayed.

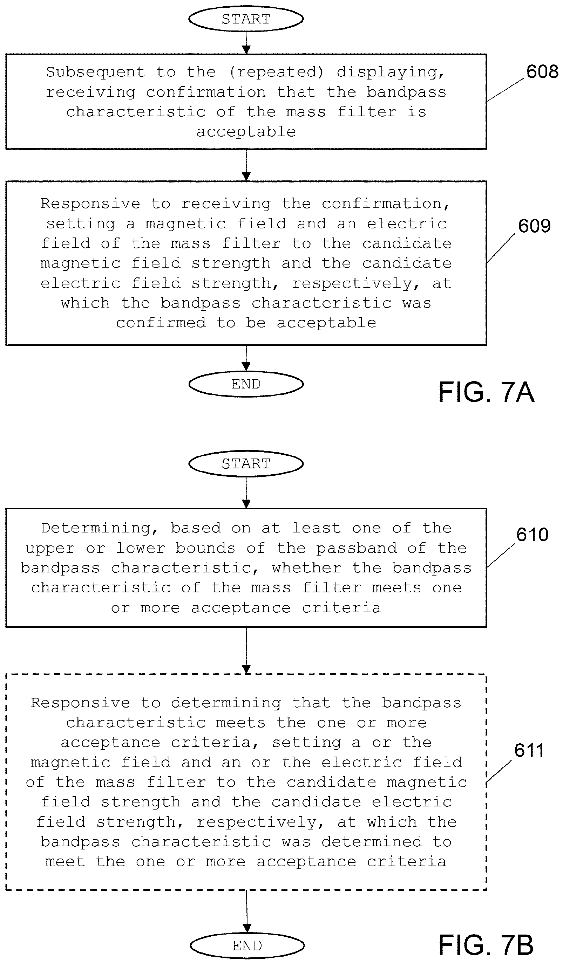

Optionally, method 600 may further comprise steps 608 to 609 shown in FIG. 7A.

At step 608, subsequent to the (optionally repeated) displaying, confirmation may be received (e.g., from a user) that the bandpass characteristic of the static field mass filter is acceptable.

If the confirmation is not received, or a confirmation that the bandpass characteristic of the static field mass filter is not acceptable is received, then steps 601 to 607 may be repeated.

If the confirmation is received, suitable values of the magnetic and electric field strengths have been found, and magnetic and electric field having those strengths can be applied to the static field mass filter 204. Accordingly, at step 609, responsive to receiving the confirmation that the bandpass characteristic of the static field mass filter is acceptable, a magnetic field and an electric field of the static field mass filter 204 may be set to the current candidate magnetic field strength and the candidate electric field strength, respectively - in other words, the candidate magnetic field strength and the candidate electric field strength at which the bandpass characteristic was confirmed to be acceptable. For example, if the confirmation was received subsequent to steps 601 to 607, but prior to a repetition of steps 601 to 607, the magnetic field and the electric field of the static field mass filter 204 may be set to the first candidate magnetic field strength and the first candidate electric field strength, respectively. As another example, if the confirmation was received subsequent to a first repetition of steps 601 to 607 (but prior to a second repetition of steps 601 to 607), the magnetic field and the electric field of the static field mass filter 204 may be set to the second candidate magnetic field strength and the second candidate electric field strength, respectively.

Optionally, method 600 may further comprise step 610 shown in FIG. 7B. Additionally and further optionally, method 600 may further comprise step 611 shown in FIG. 7B.

At step 610, based on at least one of the upper 807 or lower 808 bounds of the passband 801 of the bandpass characteristic 800B, it may be determined whether the bandpass characteristic of the static field mass filter 204 meets one or more acceptance criteria.

If the bandpass characteristic 800B of the static field mass filter 204 is determined not to meet the one or more acceptance criteria, then steps 601 to 604 (and, optionally, 607) may continue to be repeated until the bandpass characteristic is determined to meet the one or more acceptance criteria.

If the bandpass characteristic is determined to meet the one or more acceptance criteria, suitable values of the magnetic and electric field strengths have been found, and can be applied to the static field mass filter 204. Accordingly, at step 611, responsive to determining that the bandpass characteristic 800B meets the one or more acceptance criteria, the magnetic field and the electric field of the static field mass filter may be set to the candidate magnetic field strength (e.g., 905) and the candidate electric field strength (e.g., 906), respectively, at which the bandpass characteristic was determined to meet the one or more acceptance criteria.

Determining whether the bandpass characteristic 800B of the static field mass filter 204 meets one or more acceptance criteria may comprise comparing at least one of the upper 807 or lower 808 bound of the passband 801 of the bandpass characteristic 800B of the static field mass filter 204 with at least one of: the mass of a carrier gas of the mass spectrometer, the operating mass range of one or more multicollector detectors of the mass spectrometer, or the mass range of one or more elements or molecules of interest. The comparing may, for example, be to ensure that:

- the mass of the carrier gas does not fall between the upper and lower bound of the passband;

- the range formed by the upper and lower bound of the passband falls within the operating mass range; and/or

- the mass range of the one or more elements or molecules of interest falls within the range formed by the upper and lower bound of the passband.

In some implementations, method 600 may further comprise, based on the relationship between centre mass 800A and the bandpass characteristic 800B, determining the width 805 of a lower flank 802 of the bandpass characteristic 800B and the width 806 of an upper flank 803 of the bandpass characteristic 800B. The determining of the upper bound 807 may further comprise adding a third predetermined fraction 806A of the determined width 806 of the upper flank 803 to the determined centre mass 800A. The determining of the lower bound 808 may further comprise subtracting a fourth predetermined fraction 805A of the determined width 805 of the lower flank 802 from the determined centre mass 800A.

Various operations may be described as multiple discrete actions or operations in turn, in a manner that is most helpful in understanding the subject matter disclosed herein. However, the order of description should not be construed as to imply that these operations are necessarily order dependent. In particular, these operations may not be performed in the order of presentation. Operations described may be performed in a different order from the described implementation. Various additional operations may be performed, and/or described operations may be omitted in additional implementations. Operations are illustrated once each and in a particular order in FIGs. 6, 7A, and 7B, but the operations may be reordered and/or repeated as desired and appropriate (e.g., different operations performed may be performed in parallel, as suitable).

The approaches described herein may be embodied on a computer-readable medium, which may be a non-transitory computer-readable medium. The computer-readable medium carries computer-readable instructions arranged for execution upon a processor so as to make the processor carry out any or all of the methods described herein.

The term "computer-readable medium" as used herein refers to any medium that stores data and/or instructions for causing a processor to operate in a specific manner. Such storage medium may comprise non-volatile media and/or volatile media. Non-volatile media may include, for example, optical or magnetic disks. Volatile media may include dynamic memory. Exemplary forms of storage medium include, a floppy disk, a flexible disk, a hard disk, a solid state drive, a magnetic tape, or any other magnetic data storage medium, a CD-ROM, any other optical data storage medium, any physical medium with one or more patterns of holes, a RAM, a PROM, an EPROM, a FLASH-EPROM, NVRAM, and any other memory chip or cartridge. The computer-readable medium may be transitory (e.g., a wire or a wireless propagation medium in which a signal is being transmitted) or non-transitory.

For the purposes of the present disclosure, the phrases "A and/or B" and "A or B" mean (A), (B), or (A and B). For the purposes of the present disclosure, the phrases "A, B, and/or C" and "A, B, or C" mean (A), (B), (C), (A and B), (A and C), (B and C), or (A, B, and C). Although some elements may be referred to in the singular (e.g., "a processing device"), any appropriate elements may be represented by multiple instances of that element, and vice versa. For example, a set of operations described as performed by a processing device may be implemented with different ones of the operations performed by different processing devices.

The description uses the phrases "an implementation", "various implementations", and "some implementations", each of which may refer to one or more of the same or different implementations. Furthermore, the terms "comprising", "including", "having", and the like, as used with respect to embodiments of the present disclosure, are synonymous. When used to describe a range of dimensions, the phrase "between X and Y" represents a range that includes X and Y. As used herein, an "apparatus" may refer to any individual device, collection of devices, part of a device, or collections of parts of devices. The drawings are not necessarily to scale.

Those skilled in the art will recognise that the scope of the invention is not limited by the examples described herein, but is instead defined by the appended claims.

**Claims**

1. A computer-implemented method of simulating a mass filter of a mass spectrometer, the mass filter comprising a first Wien filter and a second Wien filter and having a bandpass characteristic, and the method comprising:

receiving a first candidate magnetic field strength and a first candidate electric field strength of the mass filter, wherein the candidate magnetic field strength and the candidate electric field strength are field strengths of the first and second Wien filters;
based on the received first candidate magnetic and electric field strengths, determining a corresponding centre mass of the mass filter;
based on the received first candidate magnetic and electric field strengths, determining the width of a passband of the bandpass characteristic; and
determining at least one of a lower or an upper bound of the passband of the bandpass characteristic of the mass filter.

2. The method of claim 1, wherein the determining of the upper bound comprises adding a first predetermined fraction of the determined width of the passband to the determined centre mass and the determining of the lower bound comprises subtracting a second predetermined fraction of the determined width of the passband from the determined centre mass.

3. The method of any preceding claim, further comprising displaying the at least one of the upper or lower bound of the passband of the bandpass characteristic of the mass filter.

4. The method of any preceding claim, further comprising:

receiving a centre mass, optionally from a user; and
based on the received centre mass, determining a first updated electric field strength of the mass filter,
optionally wherein the method further comprises displaying the first updated electric field strength.

5. The method of any preceding claim, further comprising:

receiving a second candidate magnetic field strength and a second candidate electric field strength of the mass filter; and
repeating, based on the received second candidate magnetic and electric field strengths, the determining of the corresponding centre mass, the determining of the width of the passband of the bandpass characteristic, and the determining of the at least one of the lower or the upper bound of the passband of the bandpass characteristic.

6. The method of claim 5, further comprising displaying the at least one of the upper or lower bound of the passband of the bandpass characteristic of the mass filter,

wherein the repeating comprises repeating the determining of the corresponding centre mass, the determining of the width of the passband of the bandpass characteristic, the determining of the at least one of the lower or the upper bound of the passband of the bandpass characteristic, and the displaying,

wherein the first candidate magnetic field strength, the first candidate electric field strength, the second candidate magnetic field strength, and the second candidate electric field strength are received from a user,

optionally wherein the method further comprises:

subsequent to the repeated displaying, receiving confirmation that the bandpass characteristic of the mass filter is acceptable;

responsive to receiving the confirmation, setting a magnetic field and an electric field of the mass filter to the second candidate magnetic field strength and the second candidate electric field strength, respectively.

7. The method of any preceding claim, further comprising:

displaying a mass of a carrier gas of the mass spectrometer; and

optionally, responsive to determining that the mass of the carrier gas is between the upper and lower bound of the passband of the bandpass characteristic of the mass filter, displaying a warning.

8. The method of any preceding claim, further comprising:
displaying an operating mass range of one or more multicollector detectors of the mass spectrometer.

9. The method of any preceding claim, further comprising:

displaying a mass range of an element or molecule of interest,

optionally wherein the method further comprises receiving from the user a selection of the element or molecule of interest from a plurality of elements and/or molecules.

10. The method of any preceding claim, further comprising determining, based on at least one of the upper or lower bounds of the passband of the bandpass characteristic, whether the bandpass characteristic of the mass filter meets one or more acceptance criteria.

11. The method of claim 10 when dependent on claim 5, wherein the repeating is until the bandpass characteristic meets the one or more acceptance criteria.

12. The method of any of claims 10 to 11, further comprising, responsive to determining that the bandpass characteristic meets the one or more acceptance criteria, setting a or the magnetic field and an or the electric field of the mass filter to the candidate magnetic field strength and the candidate electric field strength, respectively, at which the bandpass characteristic was determined to meet the one or more acceptance criteria.

13. The method of any of claims 10 to 12, wherein determining whether the bandpass characteristic of the mass filter meets one or more acceptance criteria comprises comparing at least one of the upper or lower bound of the passband of the bandpass characteristic of the mass filter with at least one of: the mass of a carrier gas of the mass spectrometer, the operating mass range of one or more multicollector detectors of the mass spectrometer, or the mass range of an element or molecule of interest.

14. The method of any preceding claim, further comprising, based on the received first candidate magnetic and electric field strengths, determining the width of a lower flank of the bandpass characteristic and the width of an upper flank of the bandpass characteristic, and

wherein the determining of the upper bound further comprises adding a third predetermined fraction of the determined width of the upper flank to the determined centre mass and the determining of the lower bound further comprises subtracting a fourth predetermined fraction of the determined width of the lower flank from the determined centre mass.

15. An apparatus configured to perform the method of any preceding claim, or a computer-readable medium comprising instructions which, when executed by a processor of an apparatus, cause the apparatus to perform the method of any preceding claim.

SUPPORT MODULE 1000

FIRST LOGIC
1002

SECOND LOGIC
1004

THIRD LOGIC
1006

# FIG. 1

FIG. 2A

FIG. 2B

3000

DATA DISPLAY REGION
3002

DATA ANALYSIS REGION
3004

CONTROL REGION
3006

SETTINGS REGION
3008

## FIG. 3

COMPUTING DEVICE 4000

PROCESSING DEVICE
4002

BATTERY/POWER
4008

STORAGE DEVICE
4004

DISPLAY DEVICE
4010

INTERFACE DEVICE
4006

OTHER I/O DEVICES
4012

## FIG. 4

FIG. 5

600      ( START )

```
┌─────────────────────────────────────────┐
│  Receiving a first candidate magnetic    │      601
│  field strength and a first candidate    │
│  electric field strength of the mass     │
│  filter                                  │
└─────────────────────────────────────────┘
```

```
┌─────────────────────────────────────────┐
│  Based on the received first candidate   │      602
│  magnetic and electric field strengths,  │
│  determining a corresponding centre of   │
│  mass of the mass filter                 │
└─────────────────────────────────────────┘
```

```
┌─────────────────────────────────────────┐
│  Based on the received first candidate   │      603
│  magnetic and electric field strengths,  │
│  determining the width of a passband of  │
│  the bandpass characteristic             │
└─────────────────────────────────────────┘
```

```
┌─────────────────────────────────────────────┐
│  Determining at least one of a lower or an   │
│  upper bound of the passband of the bandpass │
│  characteristic of the mass filter           │
│  ┌─────────────────────────────────────────┐ │
│  │  The determining of the upper bound      │ │   604A
│  │  comprising adding a first predetermined │ │
│  │  fraction of the determined width of the │ │
│  │  passband to the determined centre of    │ │   604
│  │  mass                                    │ │
│  └─────────────────────────────────────────┘ │
│  ┌─────────────────────────────────────────┐ │
│  │  The determining of the lower bound      │ │
│  │  comprising subtracting a second         │ │   604B
│  │  predetermined fraction of the determined│ │
│  │  width of the passband from the          │ │
│  │  determined centre of mass               │ │
│  └─────────────────────────────────────────┘ │
└─────────────────────────────────────────────┘
```

```
┌─ ─ ─ ─ ─ ─ ─ ─ ─ ─ ─ ─ ─ ─ ─ ─ ─ ─ ─ ─ ─ ─ ┐
│  Displaying the at least one of the upper or │   607
│  lower bound of the passband of the bandpass │
│  characteristic of the mass filter           │
└─ ─ ─ ─ ─ ─ ─ ─ ─ ─ ─ ─ ─ ─ ─ ─ ─ ─ ─ ─ ─ ─ ┘
```

( END )      FIG. 6

START

Subsequent to the (repeated) displaying, receiving confirmation that the bandpass characteristic of the mass filter is acceptable — 608

Responsive to receiving the confirmation, setting a magnetic field and an electric field of the mass filter to the candidate magnetic field strength and the candidate electric field strength, respectively, at which the bandpass characteristic was confirmed to be acceptable — 609

END

FIG. 7A

START

Determining, based on at least one of the upper or lower bounds of the passband of the bandpass characteristic, whether the bandpass characteristic of the mass filter meets one or more acceptance criteria — 610

Responsive to determining that the bandpass characteristic meets the one or more acceptance criteria, setting a or the magnetic field and an or the electric field of the mass filter to the candidate magnetic field strength and the candidate electric field strength, respectively, at which the bandpass characteristic was determined to meet the one or more acceptance criteria — 611

END

FIG. 7B

FIG. 8

FIG. 9A

FIG. 9B

EP 4 339 997 A1

**EUROPEAN SEARCH REPORT**

Application Number

EP 23 19 7464

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2021/013017 A1 (SCHWIETERS JOHANNES [DE] ET AL) 14 January 2021 (2021-01-14) | 1-13,15 | INV.<br>H01J49/28 |
| Y | * paragraphs [0086] – [0094]; figures 5-7 * <br> * paragraphs [0095] – [0128]; figures 8-14 * <br> ----- | 14 | |
| Y | CRAIG GRANT ET AL: "Project Vienna: A Novel Precell Mass Filter for Collision/Reaction Cell MC-ICPMS/MS", ANALYTICAL CHEMISTRY, vol. 93, no. 30, 20 July 2021 (2021-07-20) , pages 10519-10527, XP093121986, US ISSN: 0003-2700, DOI: 10.1021/acs.analchem.1c01475 Retrieved from the Internet: URL:https://pubs.acs.org/doi/pdf/10.1021/acs.analchem.1c01475> * page 10522; figures 2-4 * ----- | 14 | |
| A | Anonymous: "Why does the pre-cell mass filter of the Neoma MS/MS MC-ICP-MS revolutionize collision/reaction cell technology?", , 8 July 2022 (2022-07-08), XP093121984, Retrieved from the Internet: URL:https://www.thermofisher.com/order/catalog/product/IQLAAMGAATFARHMBNK [retrieved on 2024-01-22] * the whole document * ----- | 1-15 | **TECHNICAL FIELDS SEARCHED (IPC)**<br><br>H01J |

-/--

The present search report has been drawn up for all claims

| Place of search | Date of completion of the search | Examiner |
|---|---|---|
| The Hague | 23 January 2024 | Loiseleur, Pierre |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | PIERRET C ET AL: "A cheap and compact mass spectrometer for radioactive ions based on a Wien filter", NUCLEAR INSTRUMENTS & METHODS IN PHYSICS RESEARCH. SECTION B: BEAM INTERACTIONS WITH MATERIALS AND ATOMS, vol. 266, no. 19, 7 June 2008 (2008-06-07), pages 4551-4555, XP029141357, ISSN: 0168-583X, DOI: 10.1016/J.NIMB.2008.05.101 * the whole document * ----- | 1-15 | |
| | | | **TECHNICAL FIELDS SEARCHED (IPC)** |

The present search report has been drawn up for all claims

| Place of search | Date of completion of the search | Examiner |
|---|---|---|
| The Hague | 23 January 2024 | Loiseleur, Pierre |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

**page 2 of 2**

## ANNEX TO THE EUROPEAN SEARCH REPORT
## ON EUROPEAN PATENT APPLICATION NO.

EP 23 19 7464

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2024

| Patent document cited in search report | | Publication date | Patent family member(s) | | Publication date |
|---|---|---|---|---|---|
| US 2021013017 | A1 | 14-01-2021 | CN | 111868881 A | 30-10-2020 |
| | | | CN | 116994937 A | 03-11-2023 |
| | | | EP | 3769334 A1 | 27-01-2021 |
| | | | EP | 3901984 A1 | 27-10-2021 |
| | | | US | 2021013017 A1 | 14-01-2021 |
| | | | US | 2022223401 A1 | 14-07-2022 |
| | | | US | 2023333053 A1 | 19-10-2023 |
| | | | WO | 2019180045 A1 | 26-09-2019 |

For more details about this annex : see Official Journal of the European Patent Office, No. 12/82

**REFERENCES CITED IN THE DESCRIPTION**

**Patent documents cited in the description**

- EP 3769334 B1

- GB 2541391 A